# FASCICULE DE BREVET EUROPEEN

(11) **EP 0 307 261 B1**
(45) Date de publication et mention de la délivrance du brevet: **15.09.1993**
(21) Numéro de dépôt: 88401986.0
(22) Date de dépôt: 29.07.1988
(51) Int. Cl.: G01R 27/26

(54) **Procédé et dispositif pour l'estimation des caractéristiques électromagnétiques d'un matériau diélectrique ou magnétique**
Verfahren und Anordnung zur Abschätzung der elektromagnetischen Eigenschaften eines dielektrischen oder magnetischen Werkstoffes
Method and apparatus for the estimation of the electromagnetic characteristics of a dielectric or magnetic material

(30) Priorité: 03.08.1987 FR 8711009
(43) Date de publication de la demande: 15.03.1989
(73) Titulaire: AEROSPATIALE Société Nationale Industrielle, 75781 Paris Cédex 16 (FR)
(72) Inventeur: Guillou, Bernard Pierre Yves, F-33160 Saint Aubin du Médoc (FR); Lahitte, Pierre Victor André, F-33160 Salaunes (FR)
(74) Mandataire: Bonnetat, Christian

(56) Documents cités:
- US-A- 3 268 808
- US-A- 3 693 080
- US-A- 4 246 534
- US-A- 4 507 602
- IEEE TRANSACTIONS ON INSTRUMENTATION AND MEASUREMENT, vol. IM-28, no. 2, juin 1979, pages 109-112, IEEE, New York, US; B.P. KWOK et al.: "Time-Domain measurements for determination of dielectric properties of agricultural materials"
- JOURNAL OF PHYSICS E. SCIENTIFIC INSTRUMENTS, vol. 17, no. 1, janvier 1984, pages 30-34, The Institute of Physics, Doking, GB; M. STEEL et al.: "A precision method for measuring the complex permittivity of solid tissue in the frequency domain between 2 and 18GHz"
- PROCEEDINGS OF THE IEEE, vol. 74, no. 1, janvier 1986, pages 183-199, IEEE, New York, US; M.N. AFSAR et al.: "The measurement of the properties of materials"

## Description

La présente invention concerne un dispositif pour l'estimation des caractéristiques électromagnétiques d'un matériau diélectrique ou magnétique.

On sait que pour caractériser le comportement électromagnétique des matériaux, il est nécessaire de connaître leur permittivité et leur perméabilité relatives. On sait également que chacune de ces caractéristiques électromagnétiques (permittivité et perméabilité relatives) comporte un terme réel et un terme imaginaire.

On connaît déjà, par exemple par l'article "A complete analysis of the reflection and transmission methods for measuring the complex permeability and permittivity of materials at microwaves" paru dans ALTA FREQUENZA, Vol.36, n° 8, Août 1967, pages 757-764, Milan, IT, G.FRANCESCHETTI, ou bien encore par l'article "Time-domain measurements for determination of dielectric properties of agricultural materials" paru dans IEEE TRANSACTIONS ON INSTRUMENTATION AND MEASUREMENT, Vol. IM-28, n° 2 Juin 1979, pages 109-112, IEEE, New York, US,B.P.KWOK et al, des procédés permettant soit de mesurer directment les coefficients de réflexion et/ou de transmission d'échantillons diélectriques, soit de mesurer les termes réels et imaginaires de la permittivité et de la perméabilité relatives d'un matériau.

Ces procédés sont basés sur le fait que, si un matériau diélectrique ou magnétique reçoit une onde électromagnétique incidente, il transmet et il réfléchit cette onde en l'atténuant et en la déphasant, l'atténuation et le déphasage subis par l'onde transmise étant des fonctions de la perméabilité et de la permittivité dudit matériau et des conditions aux limites imposées sur la paroi du matériau.

Pour mettre en oeuvre de tels procédés, le brevet américain US-A-3,693,080, décrit un dispositif pour l'estimation des caractéristiques électromagnétiques d'un matériau diélectrique ou magnétique, comportant :
- une âme rigide en une matière électriquement conductrice ;
- un corps tubulaire rigide, également en une matière électriquement conductrice, entourant coaxialement ladite âme conductrice, de sorte que ladite âme et ledit corps tubulaire sont susceptibles de former une ligne coaxiale rigide ;
- des moyens pour appliquer une onde électromagnétique à hyperfréquence incidente entre ladite âme et ledit corps ;
- un logement pour une pièce annulaire d'épaisseur uniforme façonnée dans ledit matériau, cette pièce annulaire étant telle que, lorsqu'elle est disposée dans ledit logement, ses périphéries extérieure et intérieure sont respectivement en contact de frottement serré avec la surface intérieure dudit corps tubulaire et avec la surface extérieure de ladite âme; et
- des moyens pour recueillir l'onde électromagnétique transmise par ladite pièce annulaire.

Ainsi, pour utiliser ce dispositif connu :
- on façonne dans ledit matériau une pièce de forme annulaire d'épaisseur uniforme ;
- on introduit ladite pièce annulaire dans ladite ligne coaxiale ;
- on applique à ladite ligne coaxiale une onde électromagnétique incidente hyperfréquence ; et
- on examine les amplutides et/ou les phases de l'onde transmise et de l'onde réfléchie par ladite pièce tubulaire.

Dans ce dispositif connu, afin de permettre la modélisation mathématique de la mesure, on prévoit, dans la ligne coaxiale, un élément réflecteur d'onde disposé en aval de ladite pièce annulaire et on recueille l'onde transmise du côté de ladite ligne coaxiale auquel l'onde incidente est appliquée. Cet élément réflecteur d'onde est un élément électromagnétique qui établit un court-circuit entre le corps tubulaire et l'âme de la ligne coaxiale.

Dans le dispositif du brevet US-A-3,693,080, le logement pour la pièce annulaire du matériau a étudier est prévu dans une position intermédiaire de ladite ligne coaxiale, de sorte qu'il est nécessaire de prévoir un capot amovible dans ledit corps tubulaire rigide. De plus, il est également nécessaire que ladite pièce annulaire soit solidaire d'un tronçon d'âme conductrice qui doit être pourvu de moyens de solidarisation aux portions amont et aval de ladite âme, afin d'assurer la continuité électrique de celle-ci.

Par suite, non seulement l'échantillon du matériau à étudier est complexe à réaliser, puisque outre ladite pièce annulaire il doit comporter un troncon d'âme, mais encore on doit prévoir un capot amovible dans le corps tubulaire rigide. Il en résulte donc une structure complexe. De plus, notamment à cause des tolérances de fabrication dudit capot et dudit échantillon, il est pratiquement impossible que ladite pièce annulaire puisse occuper une position de référence fixe et que les positions relatives du corps tubulaire et de l'âme soient invariables, au cours d'une série de mesures. Ces imprécisions de position entraînent des erreurs de mesure, dont l'importance rend illusoires les mesures elles-mêmes.

La présente invention a pour objet de remédier à ces inconvénients.

A cette fin, selon l'invention, le dispositif pour l'estimation des caractéristiques électromagnétiques d'un matériau, comportant :
- une âme rigide en une matière électriquement conductrice ;
- un corps tubulaire rigide, également en une matière électriquement conductrice, entourant coaxialement ladite âme conductrice, de sorte que ladite âme et ledit corps tubulaire sont susceptibles de former une ligne coaxiale rigide ;
- des moyens pour appliquer une onde électromagnétique à hyperfréquence incidente entre ladite âme et ledit corps ;
- un logement pour une pièce annulaire d'épaisseur uniforme façonnée dans ledit matériau, cette pièce annulaire étant telle que, lorsqu'elle est disposée dans ledit logement, ses périphéries extérieure et intérieure sont respectivement en contact de frottement serré avec la surface intérieure dudit corps tubulaire et avec la surface extérieure de ladite âme ; et
- des moyens pour recueillir l'onde électromagnétique transmise par ladite pièce annulaire,
   est caractérisé :
   . en ce que ledit logement est prévu à une extrémité de ladite ligne coaxiale ;
   . en ce que ledit corps tubulaire est réalisé en deux parties assemblables ; et
   . en ce qu'il comporte un accessoire d'outillage pourvu d'une face plane de poussée et destiné à mettre en place ladite pièce annulaire à l'intérieur de ladite ligne coaxiale, la position finale de ladite pièce annulaire étant déterminée par butée dudit accessoire d'outillage contre ladite ligne coaxiale.

Ainsi, ledit échantillon peut n'être constitué que de ladite pièce annulaire, qui peut être facilement introduite à travers l'extrémité ouverte de ladite ligne et y occuper une position de référence fixe.

De plus, grâce à la séparation possible dudit corps tubulaire en deux parties, il est facile de démonter ledit échantillon, par exemple pour le remplacer par un autre. Par ailleurs, grâce à cette conception, les positions respectives de l'âme et du corps tubulaire restent invariables.

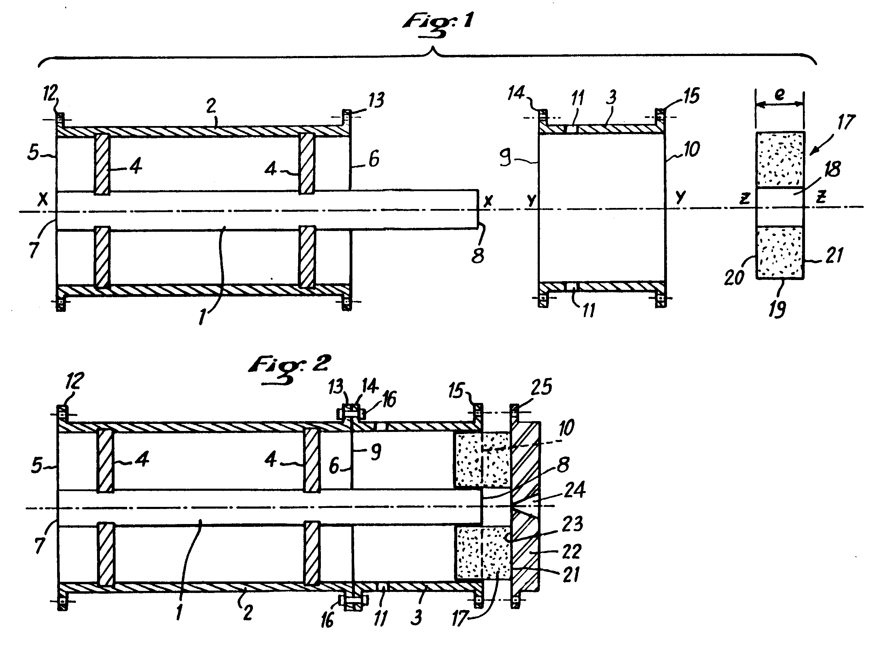

On remarquera que l'article de la revue PROCEEDINGS OF THE IEEE vol. 74 (1986) janvier, N°1, NY, USA, pages 183 à 199 prévoit déjà de disposer l'échantillon en bout de ligne, voir la page 185, figur 1. Ce dispositif ne permet pas le démontage aisé de l'échantillon.

Comme cela sera expliqué ci-après, la position de référence de l'échantillon dans le dispositif selon l'invention peut être définie par la coopération de l'élément réflecteur d'onde avec ladite ligne coaxiale. Un tel élément peut être un simple court-circuit, mais il peut également être prévu pour introduire une charge étalonnée ou connue entre ledit corps tubulaire et ladite âme. Un tel élément réflecteur peut être disposé directement en aval de ladite pièce annulaire, c'est-à-dire au contact de celle-ci, ou bien à quelque distance de ladite pièce annulaire, en aval de celle-ci.

De façon générale, un tel élément réflecteur a pour objet de mettre ladite ligne coaxiale dans un état électromagnétique déterminé et reproductible.

De préférence, on prévoit une pluralité de tels éléments réflecteurs différents, afin de pouvoir communiquer à ladite ligne coaxiale une pluralité d'états électromagnétiques déterminés qui permettent le calcul de coefficients correcteurs.

La mise en oeuvre du dispositif selon l'invention peut permettre de déterminer, par comparaison, si un matériau à examiner présente des caractéristiques électromagnétiques différentes de celles d'un matériau de référence.

Toutefois, il est de préférence utilisé pour mesurer la permittivité et la perméabilité relatives d'un matériau diélectrique ou magnétique.

On remarquera qu'une telle mesure nécessite la détermination de quatre inconnues, à savoir les termes réels et imaginaires de la permittivité et de la perméabilité. Il est donc nécessaire de procéder au moins à deux mesures en phase et en module. De telles mesures peuvent être réalisées de différentes façons : par exemple, on peut examiner plusieurs pièces d'épaisseurs différentes d'un même matériau, l'examen étant effectué grâce à l'étude seule des coefficients de réflexion (en phase et en amplitude).

Cependant, on peut n'utiliser qu'une seule pièce annulaire du matériau à examiner, et mesurer à la fois les coefficients de réflexion et de transmission. On établit alors autant de relations qu'il est nécessaire pour calculer les parties réelles et imaginaires de la permitivité et de la perméabilité du matériau constituant la pièce annulaire.

Il ressort de ce qui a été décrit précédemment que lesdits moyens pour recueillir l'onde transmise peuvent être disposés du côté de ladite ligne coaxiale opposé aux moyens d'application de l'onde incidente. Ils peuvent également être disposés du même côté de ladite ligne coaxiale que les moyens d'application de l'onde incidente.

De façon connue, afin de s'affranchir d'erreurs de mesures qui seraient dues à des variations de dispositions relatives de l'âme et du corps tubulaire, ceux-ci sont rendus solidaires l'un de l'autre par l'intermédiaire d'entretoises annulaires internes. Pour des facilités de fabrication, l'une desdites entretoises se trouve de préférence au voisinage du raccord des deux parties assemblables dudit corps tubulaire. A la même fin de facilité de fabrication, au moins une autre entretoise de la ligne coaxiale est disposée au voisinage d'une extrémité de celle-ci. De préférence, chaque entretoise est logée, à ses périphéries interne et externe, dans des gorges en regard, respectivement pratiquées dans ladite âme et dans ledit corps tubulaire.

Chacune de ces gorges est alors délimitée entre une face dudit corps tubulaire et un embout susceptible d'être assemblé audit corps et ladite âme est réalisée en plusieurs parties solidarisées les unes aux autres.

On voit ainsi que, grâce à la présente invention, on obtient un dispositif de mesure rigide, dans lequel la pièce annulaire de matériau diélectrique ou magnétique est positionnée de façon précise et est soumise à des pressions équilibrées sur ses deux faces.

Les figures du dessin annexé feront bien comprendre comment l'invention peut être réalisée. Sur ces figures, des références identiques désignent des éléments identiques.

La figure 1 illustre en coupe éclatée schématique un dispositif conforme à la présente invention.

La figure 2 montre le dispositif de la figure 1 en cours de montage.

La figure 3 illustre en coupe éclatée schématique le dispositif conforme à la présente invention avec ses accessoires de calibrage et de mesure.

La figure 4 illustre le calibrage et le processus de mesure du dispositif conforme à la présente invention.

La figure 5 montre, en coupe axiale, un mode de réalisation du dispositif conforme à la présente invention.

Le dispositif selon l'invention, illustré schématiquement par la figure 1, comporte une âme centrale 1 et un corps tubulaire en deux parties assemblables 2 et 3. L'âme centrale 1 et le corps tubulaire 2,3 sont réalisés en matières électriquement conductrices et présentent des sections circulaires.

L'âme centrale 1 et la partie de corps tubulaire 2 sont disposées coaxialement l'une à l'autre et sont maintenues mécaniquement solidaires l'une de l'ature, par l'intermédiaire d'entretoises annulaires 4 orthogonales à l'axe longitudinal X-X, commun à ladite âme centrale 1 et à ladite partie de corps tubulaire 2.

A ses deux extrémités, la partie de corps tubulaire 2 se termine par des faces d'extrémité annulaires planes, respectiviement 5 et 6, orthogonales à l'axe X-X. De même, l'âme centrale 1 est délimitée par deux faces d'extrémités planes et orthogonales à l'axe X-X, protant respectivement les références 7 et 8. La face d'extrémité plane 7 de l'âme 1 est coplanaire avec la face d'extrémité 5 de la partie de corps tubulaire 2, alors que, au contraire, la face d'extrémité plane 8 de l'âme 1 est en saillie par rapport à la face correspondante 6 de la partie de corps tubulaire 2.

La partie de corps tubulaire 3 est délimitée par deux faces d'extrémité annulaires et planes, respectiviement 9 et 10, orthogonales à son axe Y-Y. Des trous d'évent 11 sont prévus dans sa paroi latérale.

A leurs extrémités 5,6,9 et 10, les parties 2 et 3 de corps tubulaire sont pourvues de moyens, respectivement 12,13,14 et 15, représentés schématiquement sous forme de brides et destinés à leur fixation à d'autres éléments.

Les parties 2 et 3 du corps tubulaire peuvent être assemblées rigidement l'une à l'autre, grâce aux moyens 13 et 14 par exemple associés à des vis et écrous 16 (voir la figure 2). Lorsque les parties 2 et 3 sont ainsi solidarisées l'une de l'autre, les axes X-X, et Y-Y sont confondus et la face d'extrémité 9 de la partie de corps 3 est apliquée contre la face d'extrémité 6 de la partie de corps 2. De plus, dans cette position desdites parties de corps 2 et 3, la face d'extémité 8 de l'âme 1 se trouve dans le plan de la face d'extrémité 10 de la partie de corps 3.

On voit qu'ainsi le dispositif selon l'invention, composé de l'âme 1 et du corps 2,3 forme une ligne coaxiale rigide pouvant être reliée, du côté des faces d'extrémité 5 et 7, à un générateur d'hyperfréquence.

Pour pouvoir examiner les propriétés électromagnétiques d'une matière diélectrique et/ou magnétique à l'aide du dispositif 1-3 décrit ci-dessus, on usine dans ladite matière au moins une pièce 17, de forme annulaire. Le diamètre du trou central 18 de ladite pièce annulaire 17 est tel que l'emmanchement de celle-ci sur l'âme centrale 1 se fait à frottement serré. De même, le diamètre de la périphérie extérieure 19 de ladite pièce annulaire 17 est tel que l'introduciton de celle-ci dans la partie de corps 3 se fait également à frottement serré. Ainsi, lorsque les parties de corps 2 et 3 sont assemblées et que l'on introduit une pièce 17 dans la partie de corps 3, à travers la face d'extrémité 10, cette pièce est en excellent contact électrique, à la fois avec l'âme 1 et avec le corps 2,3.

Par ailleurs, la pièce 17 est délimitée par des faces planes d'extrémité, 20 et 21, parallèles entre elles et orthogonales à l'axe Z-Z de ladite pièce.

Sur la figure 2, on a représenté une pièce 17 en cours de mise en place dans la partie de corps 3. Cette pièce 17 est poussée à l'aide d'un accessoire d'outillage 22 présentant une face plane 23, s'appliquant sur la face 21 de ladite pièce. L'accessoire d'outillage 22 comporte au moins un trou d'évent 24 pour l'évacuation de l'air emprisonné dans le trou 18 de la pièce 17, entre la face d'extrémité 8 de l'âme 1 et ledit accessoire d'outillage. On conçoit que l'air emprisonné à l'intérieur de la partie de corps 3, entre la pièce 17 et l'âme 1, peut s'échapper par les trous d'évent 11, au cours de l'introduction de ladite pièce.

L'accessoire d'outillage 22 comporte des moyens 25 pouvant coopérer avec les moyens 15 de la partie de corps 3 pour le fixer sur cette dernière. Lorsque l'assemblage de l'accessoire d'outillage 22 sur la partie de corps 3 est terminé, on est sûr que l'axe Z-Z de la pièce 17 est confondu avec les axes X-X et Y-Y et que la face annulaire plane 21 est coplanaire avec les faces d'extrémité 8 et 10 de l'âme 1 et de la partie de corps 3. L'accessoire d'outillage 22 est alors éventuellement démonté, à moins qu'il ne serve de plus d'accessoire de court-circuit, comme cela sera décrit ci-après.

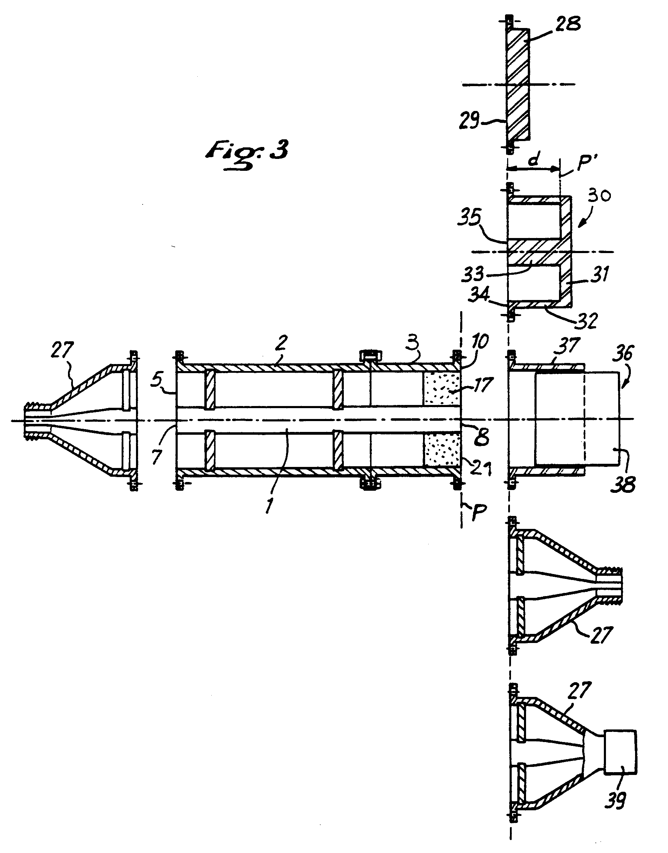

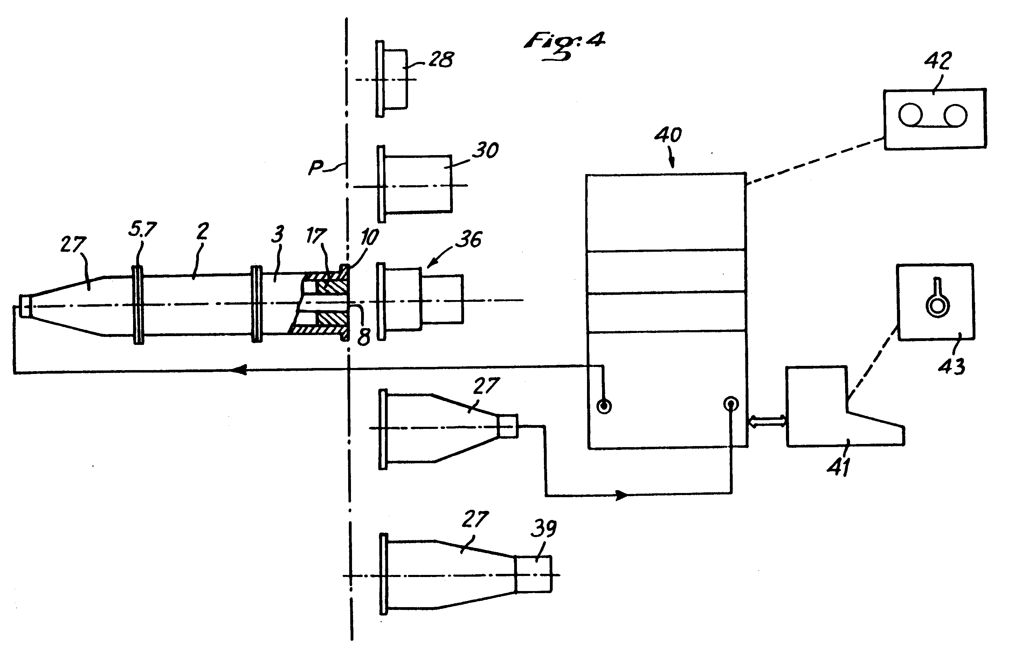

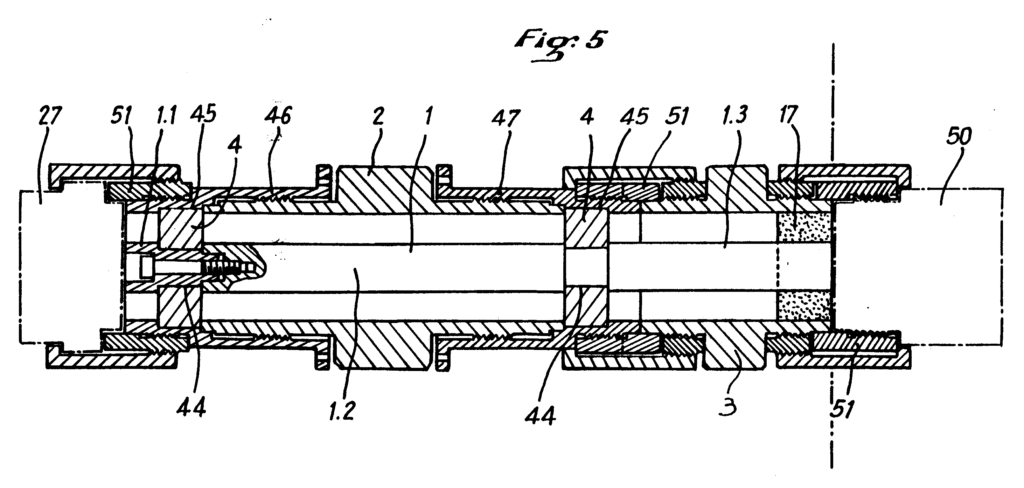

Sur la figure 3, on a représenté la pièce 17 en place dans le dispositif 1-3 et on a désigné par P, le plan commun aux faces 8,10 et 21.

On conçoit aisément que, si on applique une onde à hyperfréquence incidente entre la face d'extrémité 5 du corps 2,3 et la face d'extrémité 7 de l'âme 1, cette onde va se propager à travers la ligne 1-3 jusqu'à la pièce 17. Par suite, cette onde incidente va traverser la pièce 17. Dans sa traversée de la pièce 17, l'onde électromagnétique a une vitesse de propagation qui, de façon connue, est une fonction de la permittivité relative et de la perméabilité relative du matériau constituant la pièce 17. L'épaisseur e de la pièce 17 étant connue, il suffit donc de connaître le temps de propagation de l'onde dans ladite pièce pour obtenir une relation liant les permittivité et perméabilité relatives du matériau de la pièce 17. Or, ce temps de propagation des ondes dans la pièce correspond au déphasage de l'onde transmise par ladite pièce annulaire 17 par rapport à l'onde incidente. De plus, l'atténuation subie par l'onde électromagnétique pendant sa traversée de la pièce 17 est également une fonction de la perméabilité et de la permittivité relatives du matériau de ladite pièce. Ainsi, si on effectue plusieurs mesures ce déphasage et d'atténuation avec des pièces de même matériau, mais d'épaisseurs e différentes, et/ou avec états différents pour la ligne 1-3, on obtient des équations grâce auxquelles on peut calculer la permittivité et la perméabilité relatives dudit matériau.

Sur la figure 3, on a représenté, en plus de la ligne coaxiale 1-3, différents accessoires permettant de raccorder ladite ligne à un générateur et à un récepteur d'onde électromagnétique et d'imposer à ladite ligne coaxiale un état électromagnétique connu et reproductible. Il s'agit essentiellement :
- de raccords coaxiaux 27 permettant de relier les extrémités de ladite ligne 1-3, d'une part à un générateur d'onde électromagnétique incidente et d'autre part à un récepteur d'onde électromagnétique transmise par ladite pièce 17. De tels raccords coaxiaux 27 sont de préférence du type décrit dans la demande de brevet francais FR-A 2 619 253 déposée le 3 Août 1987 au nom de la Demanderesse (publiée le 1 Mars 1989 comme demande européenne EP-A- 0 305 247) pour "Dispositif pour le raccord de deux structures pour hyperfréquences, coaxiales et de diamètres différents" ;
- des courts-circuits 28 permettant d'établir un court-circuit électromagnétique entre l'âme 1 et le corps tubulaire 2,3 au niveau du plan P. De tels courts-circuits peuvent être identiques à l'accessoire 22. Ils sont essentiellement constitués par une plaque de matériau électriquement conducteur comportant une face plane 29 (ou 23), susceptible de s'appliquer simultanément sur les faces d'extrémité 10 et 8 du corps 2,3 de l'âme 1 ;
- de courts-circuits 30 permettant un court-circuit électromagnétique entre l'âme 1 et le corps tubulaire 2,3 dans un plan P′, décalé d'une distance fixe d en aval du plan P. Ils sont essentiellement constitués par une pièce de matériau électriquement conducteur comportant un plaque 31, prolongée en direction de la ligne 1-3, par une enveloppe 32 et par un noyau 33 coaxiaux. La plaque 31 est orthogonale à ladite enveloppe et audit noyau et ceux-ci comportent des faces 34 et 35 pouvant venir s'appliquer respectivement contre la face 10 du corps tubulaire 2,3 et contre la face 8 de l'âme 1 ;
- de circuits ouverts 36 constitués d'une enveloppe 37, destinée à prolonger le corps tubulaire 2,3, et d'un noyau diélectrique, magnétique ou conducteur réglable 38, coulissant dans ladite enveloppe ;
- de charges étalonnées 39, de type connu et par exemple de l'ordre de 50 ohms, suceptibles d'être reliées à la ligne 1-3 par l'intermédiaire d'un raccord coaxial 27.

Comme le montre schématiquement la figure 4, cette instrumentation 1-3, 27, 28, 30, 36 et 39 est complétée par un système de calcul et d'analyse de réseau, tel que par exemple celui commercialsé par la Société HEWLETT PACKARD sous la référence HP 8510, associé à un calculateur 41 (par exemple du type HP 9836). Cet ensemble reçoit des données relatives au système de mesure (figure 3) contenu dans la mémoire 42 et un programme de mesure et le traitement mathématique 43.

On conçoit que le système montré par la figure 4 peut fonctionner de différentes façons.

Tout d'abord, il est possible, en branchant un raccord coaxial 27 à chaque extrémité de la ligne 1-3, de fonctionner en transmission directe, d'une exrémité de la ligne à l'autre. Dans ce cas, l'onde incidente est appliquée à l'extrémité 5,7 de la ligne 1-3 et l'onde transmise est recueillie à l'extrémité 8,10 de cette ligne. Au contraire, l'extrémité 8,10 de la ligne 1-3 peut être reliée à l'un des dispositifs 28, 30, 36 ou 39, de sorte qu'alors l'onde électromagnétique est réfléchie et est recueillie à l'extrémité 5, 7, à laquelle l'onde incidente est appliquée.

De même, on peut comparer directement les propriétés électromagnétiques de deux matériaux différents, par mesure des coefficients de transmission ou par mesure des coefficients de réflexion sans mesure des permittivité et perméabilité relatives, ou bien encore utiliser le système pour déterminer uniquement l'atténuation produite par un matériau déterminé.

Cependant, dans un mode avantageux de mise en oeuvre du système de la figure 4 :
- on commence par effectuer des opérations de calibrage de la ligne coaxiale 1-3 à vide, c'est-à-dire ne comportant pas de pièce annulaire 17, cette ligne étant soit en transmission directe (un raccord coaxial 27 à chaque extrémité), soit en réflexion (un raccord coaxial 27 relié à l'extrémité 5, 7 et un dispositif 28, 30, 36 ou 27, 39 relié à l'extrémité 8, 10). Cette opération de calibrage permet au système 40 de calculer les coefficients d'erreur nécessaires à la mesure précise de coefficients de réflexion et de trasmission de l'échantillon 17.
- puis, on met en place une pièce annulaire 17 en un matériau diélectrique ou magnétique et on redonne à la ligne coaxiale 1-3 une configuratin identique à celle du calibrage précédent. De plus, on applique alors à ladite ligne coaxiale 1-3 la même onde électromganétique incidente qu'au cours du calibrage. Le système 40 détermine alors les coefficients de réflexion etou de transmission qui en résultent.

Ensuite, le système 40 détermine le coefficient de réflexion et/ou de transmission propres à la pièce annulaire 17 en cours d'examen, en utilisant les coefficients d'erreur, mesurés au cours de la phase de calibrage et calculés par le système 40.

On recommence la suite des opérations précédentes plusieurs fois, avec des configurations de lignes différentes, pour obtenir suffisamment de mesures permettant de calculer, aisni que de confirmer, les valeurs réelles et imaginaires de la perméabilité et de la permittivité.

Sur la figure 5, on a représenté un mode de réalisation pratique de la ligne coaxiale rigide 1-3. On peut y voir que les entretoises 4 sont disposées aux extrémités de la partie de corps 2 et sont engagées, par leurs périphéries intérieures et extérieures dans des gorges 44 et 45, respectivement pratiquées dans l'âme 1 et dans le corps tubulaire 2,3. Pour pouvoir mettre en place ces entretoises 4, on prévoit des embouts 46,47 se fixant sur ladite partie de corps tubulaire 2 et sur lesquels se fixent respectivement, un raccord coaxial 27 et ladite partie de corps tubulaire 3. De plus, l'âme 1 est réalisée en plusieurs parties 1.1, 1.2 et 1.3 assemblables entre elles et pourvues d'épaulements à leurs extrémités respectives. L'assemblage de ces différentes parties de l'âme 1 peut être obtenu par tous moyens connus, mais, de préférence, il est réalisé grâce au joint décrit dans la demande de brevet français FR-A-2 619 252 déposée le 3 Août 1987 au nom de la Demanderesse (publiée le 22 février 1989 comme demande européenne EP-A-0 304 365) pour "Système de liaison à joint pour éléments travaillant en hyperfréquence". Ain cours d'un processus de mesure, lesdites parties 1.1, 1.2 et 1.3 restent solidaires les unes des autres.

La pièce annulaire 17 est logée dans la partie de corps tubulaire 3 et est maintenue en place par le dispositif 27, 28, 30 ou 36 (portant la référence commune 50 sur la figure 5) qui vient se fixer sur la partie de corps tubulaire 3.

Des doigts de guidage et de centrage 51 sont prévus entre les différents éléments pour faciliter le montage. De préférence, les différents assemblages sont réalisés par vissage.

On remarquera qu'il est important que l'âme 1 et le corps tubulaire 2, 3 soient solidarisés l'un de l'autre par des entretoises 4. Ces dernières permettent de fixer les positions relatives de ces éléments, et donc, assurent une mise en place répétitive des pièces annulaires 17 et, de plus, autorisent un diamètre important au corps tubulaire 2,3. Ainsi, il est possible d'utiliser des pièces 17 de grands diamètres, ce qui est important pour l'étude des matériaux dont l'homogénéité n'est pas microscopique. Bien entendu, on procède à des réglages préliminaires pour que les entretoises apportent le minimum de perturbations à la propagation des ondes électromagnétiques. Au cours de ces réglages, de la matière peut être enlevée ou ajoutée auxdites entretoises pour que les ondes parasites réfléchies par elles aient le minimum d'amplitude.

Grâce à la structure de la ligne coaxiale 2,3 de l'invention, on voit :
- que la position d'une pièce annulaire ne bouge pas lorsqu'on échange les dispositifs 27, 28, 30, 36, 50 entre eux ;
- qu'une pièce annulaire 17 peut être enlevée et remplacée par une autre sans changer les positions relatives de l'âme 1 et du corps 2, 3. En effet, après démontage de la partie 3 pour sortir une pièce 17 (la partie 1.3 de l'âme 1 restant solidaire de la partie 1.2), cette partie 3 retrouve une position identique à celle qu'elle occupait précédemment, dès qu'elle est de nouveau fixée à la partie 2 ; et
- que toutes les pièces 17 successives occupent la même position à l'intérieur de l'extrémité de la partie 3 du corps tubulaire.

## Revendications

1. Dispositif pour l'estimation des caractéristiques électromagnétiques d'un matériau, comportant :
- une âme rigide (1) en une matière électriquement conductrice ;
- un corps tubulaire rigide (2,3), également en une matière électriquement conductrice, entourant coaxialement ladite âme conductrice, de sorte que ladite âme et ledit corps tubulaire sont susceptibles de former une ligne coaxiale rigide ;
- des moyens (27) pour appliquer une onde électromagnétique à hyperfréquence incidente entre ladite âme et ledit corps ;
- un logement pour une pièce annulaire (17) d'épaisseur uniforme façonnée dans ledit matériau, cette pièce annulaire étant telle que, lorsqu'elle est disposée dans ledit logement, ses périphéries extérieure et intérieure sont respectivement en contact de frottement serré avec la surface intérieure dudit corps tubulaire et avec la surface extérieure de ladite âme ; et
- des moyens (27) pour recueillir l'onde électromagnétique transmise par ladite pièce annulaire,
caractérisé :
. en ce que ledit logement est prévu à une extrémité de ladite ligne coaxiale ;
. en ce que ledit corps tubulaire (2,3) est réalisé en deux parties assemblables ; et
. en ce qu'il comporte un accessoire d'outillage (22) pourvu d'une face plane de poussée (23) et destiné à mettre en place ladite pièce annulaire (17) à l'intérieur de ladite ligne coaxiale (2,3), la position finale de ladite pièce annulaire étant déterminée par butée dudit accessoire d'outillage contre ladite ligne coaxiale.

2. Dispositif selon la revendication 1, comportant un élément réflecteur d'onde disposé en aval de ladite pièce annulaire (17),
caractérisé en ce que ledit élément réflecteur d'onde est un élément électromagnétique (28,30) établissant un court-circuit entre le corps tubulaire et l'âme de la ligne coaxiale.

3. Dispositif selon la revendication 1, comportant un élément réflecteur d'onde disposé en aval de la dite pièce annulaire (17),
caractérisé en ce que ledit élément réflecteur d'onde est un élément électromagnétique introduisant une charge étalonnée (39) entre le corps tubulaire et l'âme de la ligne coaxiale.

4. Dispositif selon l'une des revendications 2 ou 3,
caractérisé en ce que l'on prévoit une pluralité d'éléments réflecteurs différents interchangeables.

5. Dispositif selon l'une quelconque des revendications 1 à 4, dans lequel ladite âme et ledit corps tubulaire sont rendus solidaires l'un de l'autre par l'intermédiaire d'entretoises annulaire internes (4),
caractérisé en ce que l'une desdites entretoises se trouve au raccord de deux parties assemblables dudit corps tubulaire.

6. Dispositif selon la revendication 5,
caractérisé en ce qu'au moins une autre entretoise de la ligne coaxiale est disposée à l'extrémité de celle-ci opposée audit raccord de deux parties assemblables.

7. Dispositif selon l'une quelconque des revendications 5 ou 6,
caractérisé en ce que chaque entretoise est logée, à ses périphéries interne et externe, dans des gorges (44,45) en regard, respectivement pratiquées dans ladite âme et dans ledit corps tubulaire.

8. Dispositif selon la revendication 7,
caractérisé en ce que chacune desdites gorges est délimitée entre une face dudit corps tubulaire et un embout (46,47) susceptible d'être assemblé audit corps et en ce que ladite âme (1) est réalisée en plusieurs parties (1.1 à 1.3) solidarisées les unes des autres.

9. Dispositif selon l'une quelconque des revendications 1 à 8,
caractérisé en ce que lesdits moyens pour recueillir l'onde transmise sont disposés du côté de ladite ligne coaxiale opposé aux moyens d'application de l'onde incidente.

10. Dispositif selon l'une quelconque des revendications 1 à 8,
caractérisé en ce que lesdits moyens pour recueillir l'onde réfléchie sont disposés du même côté de ladite ligne coaxiale que le moyens d'application de l'onde incidente et en ce qu'au moins un élément de réflexion d'onde (28, 30, 36, 39) est susceptible d'être disposé en aval de ladite pièce annulaire.

## Claims

1. A device for estimating the electromagnetic characteristics of a material, comprising:
- a rigid core (1) of an electrically conducting material;
- a rigid tubular body (2, 3) also of an electrically conducting material coaxially surrounding the conducting core such that the core and the tubular body are able to form a rigid coaxial line;
- means (27) adapted to supply an incident ultrahigh frequency electromagnetic wave between the core and the body;
- a housing for an annular member (17) of uniform thickness formed in the material, this annular member being such that when it is disposed in the housing, its outer and inner peripheries are respectively in close frictional contact with the inner surface of the tubular body and with the outer surface of the core;
- means (27) for receiving the electromagnetic wave transmitted by the annular member, characterized in that:
- the housing is provided at one end of the coaxial line;
- the tubular body (2, 3) is made from two portions which may be assembled;
- it comprises a tool accessory (22) provided with a plane thrust surface (23) and adapted to position the annular member (17) within the coaxial line (2, 3), the final position of the annular member being determined by the abutment of the tool accessory against the coaxial line.

2. A device as claimed in claim 1, comprising a wave reflector member disposed downstream of the annular member (17), characterized in that the wave reflector member is an electromagnetic member (28, 30) establishing a short circuit between the tubular body and the core of the coaxial line.

3. A device as claimed in claim 1, comprising a wave reflector member disposed downstream of the annular member (17), characterized in that the wave reflector member is an electromagnetic member introducing a calibrated load (39) between the tubular body and the core of the coaxial line.

4. A device as claimed in one of claims 2 or 3, characterized in that a plurality of different interchangeable reflector members are provided.

5. A device as claimed in any one of claims 1 to 4, in which the core and the tubular body are made rigid with one another by means of inner annular struts (4), characterized in that one of these struts is disposed at the junction of two portions of the tubular body which may be assembled.

6. A device as claimed in claim 5, characterized in that at least one other strut of the coaxial line is disposed at the end thereof opposite the junction of two portions which may be assembled.

7. A device as claimed in any one of claims 5 or 6, characterized in that each strut is housed, at its inner and outer peripheries, in facing grooves (44, 45) provided in the core and in the tubular body respectively.

8. A device as claimed in claim 7, characterized in that each of the grooves is bounded between one surface of the tubular body and a cap (46, 47) which may be assembled on the body and in that the core (1) is made from a plurality of portions (1.1 to 1.3) rigidly joined to one another.

9. A device as claimed in any one of claims 1 to 8, characterized in that the means for receiving the transmitted wave are disposed on the side of the coaxial line opposite the means for supplying the incident wave.

10. A device as claimed in any one of claims 1 to 8, characterized in that the means for receiving the reflected wave are disposed on the same side of the coaxial line as the means for supplying the incident wave and in that at least one wave reflector member (28, 30, 36, 39) may be disposed downstream of the annular member.

## Patentansprüche

1. Vorrichtung zur Schätzung der elektromagnetischen Eigenschaften eines Materials, die folgendes enthält:
- einen steifen Kern (1) aus einem elektrisch leitenden Material;
- einen steifen röhrenförmigen Körper (2,3), ebenfalls aus einem elektrisch leitenden Material, welcher besagten leitenden Kern koaxial umgibt, so daß besagter Kern und besagter rohrförmige Körper eine steife koaxiale Leitung bilden können;
- Mittel (27) zum Anlegen einer einfallenden elektromagnetischen Ultrahochfrequenzwelle zwischen besagtem Kern und besagtem Körper;
- eine Aufnahme für ein ringförmiges Teil (17) regelmäßiger Stärke aus dem gleichen Material geformt, wobei dieses ringförmige Teil so ausgelegt ist, daß, wenn es sich in dieser Aufnahme befindet, sein äußerer und innerer Umfang sich jeweils mit der inneren Fläche des genannten Körpers und mit der äußeren Fläche des besagten Körpers in engem Reibungskontakt befinden; und
- Mittel (27) zum Aufnehmen der vom besagten ringförmigen Teil übertragenen elektromagnetischen Welle,
dadurch gekennzeichnet, daß:
. besagte Aufnahme für ein Ende der besagten koaxialen Leitung vorgesehen ist;
. besagter rohrförmige Körper (2,3) aus zwei zusammenfügbaren Teilen hergestellt ist; und
. sie ein Werkzeugzubehör (22) enthält mit einer ebenen Andruckfläche (23) und die Aufgabe hat besagtes ringförmige Teil (17) im Innern der besagten koaxialen Leitung (2,3) anzubringen, wobei die Endlage des besagten ringförmigen Teils durch Anschlag des besagten Werkzeugzubehörs an besagte koaxiale Leitung festgelegt wird.

2. Vorrichtung nach Anspruch 1, die ein Wellenreflektorelement unterhalb des besagten ringförmigen Teils (17) enthält,
dadurch gekennzeichnet, daß das Wellenreflektorelement aus einem elektromagnetischen Element (28, 30) besteht das einen Kurzschluß zwischen dem rohrförmigen Körper und dem Kern der koaxialen Leitung herstellt.

3. Vorrichtung nach Anspruch 1, die ein Wellenreflektorelement unterhalb des besagten ringförmigen Teils (17) enthält,
dadurch gekennzeichnet, daß das besagte Wellenreflektorelement aus einem elektromagnetischen Element besteht, das eine geeichte Ladung (39) zwischen dem rohrförmigen Körper und dem Kern der koaxialen Leitung einbringt.

4. Vorrichtung nach einem der Ansprüche 2 oder 3, dadurch gekennzeichnet, daß eine Vielzahl verschiedener austauschbarer Reflektorelemente vorsieht.

5. Vorrichtung nach irgendeinem der Ansprüche 1 bis 4, in welchem besagter Kern und besagter rohrförmiger Körper mittels ringförmiger interner Stege (4) verbunden sind, dadurch gekennzeichnet, daß einer der besagten Stege sich in der Verbindung zwischen zwei zusammengefügten Teilen des besagten rohrförmigen Körpers befindet.

6. Vorrichtung nach Anspruch 5,
dadurch gekennzeichnet, daß mindestens ein anderer Steg der koaxialen Leitung am Ende derselben das sich gegenüber der besagten Verbindung der zusammengefügten Teile befindet, angebracht ist.

7. Vorrichtung nach irgend einem der Ansprüche 5 oder 6, dadurch gekennzeichnet, daß jeder Steg mit seinem inneren und äußeren Umfang in gegenüberliegende Rillen (44, 45) die jeweils in dem besagten Kern und in dem besagten rohrförmigen Körper angelegt sind, gelagert ist.

8. Vorrichtung nach Anspruch 7,
dadurch gekennzeichnet, daß jede der besagten Rillen durch eine Seite des besagten rohrförmigen Körpers und einem Ansatzstück (46, 47) begrenzt ist, wobei letzteres mit dem besagten Körper verbunden werden kann und der besagte Kern (1) aus mehreren miteinander verbundenen Teilen (1.1 bis 1.3) ausgeführt ist.

9. Vorrichtung nach irgendeinem der Ansprüche 1 bis 8, dadurch gekennzeichnet, daß besagte Mittel zur Aufnahme der übertragenen Welle an der den Mittel zum Anlegen der einfallenden Welle gegenüber liegenden Seite der besagten koaxialen Leitung angeordnet sind.

10. Vorrichtung nach irgendeinem der Ansprüche 1 bis 8, dadurch gekennzeichnet, daß die Mittel zur Aufnahme der reflektierten Welle auf der gleichen Seite der besagten koaxialen Leitung wie die Mittel zum Anlegen der einfallenden Welle angeordnet sind und daß mindestens ein Wellenreflexionselement (28, 30, 36, 39) unterhalb des besagten ringförmigen Teils angeordnet werden kann.
